# EUROPEAN PATENT APPLICATION

(11) **EP 4 429 437 A1**
(43) Date of publication of application: **11.09.2024**
(21) Application number: 22941010.5
(22) Date of filing: 07.05.2022
(51) Int. Cl.: H10K 59/00

(54) **DISPLAY SUBSTRATE, DISPLAY PANEL AND DISPLAY APPARATUS**

(71) Applicant: BOE Technology Group Co., Ltd., Chaoyang District, Beijing 100015 (CN); Chengdu BOE Optoelectronics Technology Co., Ltd., Chengdu, Sichuan 611731 (CN)
(72) Inventor: WANG, Benlian, Beijing 100176 (CN); LU, Yanwei, Beijing 100176 (CN); CAI, Jianchang, Beijing 100176 (CN); WANG, Binyan, Beijing 100176 (CN); XU, Yuanjie, Beijing 100176 (CN); LIU, Cong, Beijing 100176 (CN)
(74) Representative: Cohausz & Florack
(86) International application number: PCT/CN2022/091573
(87) International publication number: WO 2023/216041

(57) **Abstract**

Embodiments of the present disclosure provide a display substrate, a display panel and a display apparatus. The display substrate includes: a base substrate; a plurality of first pixel circuits; a plurality of first light-emitting devices on one side of the first pixel circuits away from the base substrate, wherein the first light-emitting devices include first electrodes; at least one flat layer and at least one conductive layer between the first pixel circuits and the first light-emitting devices, wherein at least one of the first pixel circuits is electrically connected with the first electrode of at least one of the first light-emitting devices via the conductive layer through a via hole penetrating through the flat layer, and the via hole includes a first via hole in contact with the first electrode; and a pixel defining layer on one side of the first electrodes away from the base substrate and including an opening exposing the first electrodes, wherein an orthographic projection of the opening on the base substrate does not overlap an orthographic projection of the first via hole on the base substrate.

## Description

### Field

The present disclosure relates to the technical field of display, in particular to a display substrate, a display panel and a display apparatus.

### Background

With high-speed development of a smartphone, not only does an appearance of the smartphone need to be attractive, but also a more excellent visual experience needs to be brought for a smartphone user. Various manufacturers have started to improve a screen-to-body ratio of the smartphone, so a full screen becomes a new competition of the smartphone. With development of the full screen, improvement of performance and functions is also demanded increasingly, an under-display camera may bring visual impact and impact on using experience to a certain degree on the premise of not affecting a high screen-to-body ratio.

### Summary

Embodiments of the present disclosure provide a display substrate, a display panel and a display apparatus. The display substrate includes: a base substrate; a plurality of first pixel circuits on one side of the base substrate; a plurality of first light-emitting devices on one side of the first pixel circuits away from the base substrate, wherein each of the first light-emitting device includes a first electrode; at least one flat layer and at least one conductive layer between the first pixel circuits and the first light-emitting devices, wherein the flat layer and the conductive layer are arranged alternately, at least one of the first pixel circuits is electrically connected with the first electrode of at least one of the first light-emitting devices via the conductive layer through a via hole penetrating through the flat layer, and the via hole includes a first via hole in contact with the first electrode; and a pixel defining layer on one side of the first electrodes away from the base substrate and including an opening exposing the first electrode, wherein an orthographic projection of the opening on the base substrate does not overlap an orthographic projection of the first via hole on the base substrate.

In a possible implementation, the at least one flat layer includes: a first flat layer, and a second flat layer located on one side of the first flat layer facing the first pixel circuits; the via hole includes the first via hole penetrating through the first flat layer and a second via hole penetrating through the second flat layer; and an orthographic projection of the first via hole on the base substrate and an orthographic projection of the second via hole on the base substrate have an overlapping region, and the first via hole and the second via hole form a first group of holes.

In a possible implementation, the at least one flat layer further includes a third flat layer located between the first flat layer and the second flat layer, and a fourth flat layer located on one side of the second flat layer away from the third flat layer; the via hole further includes: a third via hole penetrating through the third flat layer and a fourth via hole penetrating through the fourth flat layer; an orthographic projection of the third via hole on the base substrate and an orthographic projection of the fourth via hole on the base substrate have an overlapping region, the third via hole and the fourth via hole form a second group of holes; and the first pixel circuit is electrically connected with the first electrode through the first group of holes and the second group of holes.

In a possible implementation, the at least one flat layer further includes a fifth flat layer located on one side of the fourth flat layer away from the second flat layer; the via hole further includes: a fifth via hole penetrating through the fifth flat layer; and an orthographic projection of the fifth via hole on the base substrate and the orthographic projection of the first via hole on the base substrate have an overlapping region, and the first group of holes further includes the fifth via hole.

In a possible implementation, an orthographic projection of the second group of holes on the base substrate does not overlap an orthographic projection of the first group of holes on the base substrate.

In a possible implementation, the plurality of first light-emitting devices include device row groups arranged in sequence in a first direction, and each device row group includes a first device row, a second device row, a third device row and a fourth device row arranged in sequence in the first direction; the first device row and the third device row each include first sub-light-emitting devices and second sub-light-emitting devices arranged alternately in sequence in a second direction, a color of light emitted from the first sub-light-emitting devices is different from a color of light emitted from the second sub-light-emitting devices; and the second device row and the fourth device row include third sub-light-emitting devices and fourth sub-light-emitting devices arranged alternately in sequence in the second direction, and a color of light emitted from the third sub-light-emitting devices is the same as a color of light emitted from the fourth sub-light-emitting devices; in the same device row group, a first row gap is between the first device row and the second device row, and a second row gap is between the third device row and the fourth device row; first groups of holes and second groups of holes configured to connect all the first light-emitting devices in the first device row as well as first groups of holes and second groups of holes configured to connect all the first light-emitting devices in the second device row are all in the first row gap and are arranged in a direction parallel to the second direction; and first groups of holes and second groups of holes configured to connect all the first light-emitting devices in the third device row as well as first groups of holes and second groups of holes configured to connect all the first light-emitting devices in the fourth device row are all in the second row gap and are arranged in a direction parallel to the second direction.

In a possible implementation, in the first row gap, spacing between centers of at least two adjacent first groups of holes in all the first groups of holes configured to connect the first electrodes is different; and in the second row gap, spacing between centers of at least two adjacent first groups of holes in all the first groups of holes configured to connect the first electrodes is different.

In a possible implementation, in the first row gap, a ratio of spacing between centers of at least two adjacent second groups of holes in all the second groups of holes configured to connect the first electrodes is in a range of 0.8-1.2; and in the second row gap, a ratio of spacing between centers of at least two adjacent second groups of holes in all the second groups of holes configured to connect the first electrodes is in a range of 0.8-1.2.

In a possible implementation, spacing between centers of at least two adjacent first groups of holes in the first row gap is different from spacing between centers of at least two adjacent first groups of holes in the second row gap.

In a possible implementation, in the first row gap, first groups of holes configured to connect the third sub-light-emitting devices, first groups of holes configured to connect the first sub-light-emitting devices, first groups of holes configured to connect the fourth sub-light-emitting devices and first groups of holes configured to connect the second sub-light-emitting devices are arranged in cycles in sequence in the second direction.

In a possible implementation, in an arrangement cycle of the first row gap, second groups of holes of the third sub-light-emitting devices are located on one side of the first groups of holes of the third sub-light-emitting devices away from the first groups of holes of the first sub-light-emitting devices; second groups of holes of the first sub-light-emitting devices are located between the first groups of holes of the first sub-light-emitting devices and the first groups of holes of the third sub-light-emitting devices; second groups of holes of the fourth sub-light-emitting devices are located between the first groups of holes of the first sub-light-emitting devices and the first groups of holes of the fourth sub-light-emitting devices; and second groups of holes of the second sub-light-emitting devices are located on one side of the first groups of holes of the second sub-light-emitting devices away from the first groups of holes of the fourth sub-light-emitting devices.

In a possible implementation, in the second row gap, first groups of holes configured to connect the third sub-light-emitting devices, first groups of holes configured to connect the first sub-light-emitting devices, first groups of holes configured to connect the fourth sub-light-emitting devices and first groups of holes configured to connect the second sub-light-emitting devices are arranged in cycles in sequence in the second direction.

In a possible implementation, in an arrangement cycle of the second row gap, second groups of holes of the third sub-light-emitting devices are located on one side of the first groups of holes of the third sub-light-emitting devices away from the first groups of holes of the first sub-light-emitting devices; second groups of holes of the first sub-light-emitting devices are located between the first groups of holes of the third sub-light-emitting devices and the first groups of holes of the first sub-light-emitting devices; second groups of holes of the fourth sub-light-emitting devices are located between the first groups of holes of the first sub-light-emitting devices and the first groups of holes of the fourth sub-light-emitting devices; and second groups of holes of the second sub-light-emitting devices are located between the first groups of holes of the fourth sub-light-emitting devices and the first groups of holes of the second sub-light-emitting devices.

In a possible implementation, a plurality of first electrodes of the plurality of first light-emitting devices include first electrode cell rows and second electrode cell rows arranged in sequence in the first direction; the first electrode cell rows include a plurality of first electrode cells arranged in sequence in the second direction, and the second electrode cell rows include a plurality of second electrode cells arranged in sequence in the second direction; and the first electrode cell and the second electrode cell each include a first sub-electrode and a second sub-electrode arranged in the first direction, and a third sub-electrode and a fourth sub-electrode arranged in the second direction.

In a possible implementation, each first electrode cell includes a first edge parallel to a long edge of the third sub-electrode and includes a second edge parallel to a long edge of the fourth sub-electrode; in the first electrode cell, the third sub-electrode includes: a third sub-electrode body and a third sub-electrode switch-over portion extending from the third sub-electrode body towards one side away from the second sub-electrode in a direction perpendicular to the first edge; and an orthographic projection of the first groups of holes configured to connect the third sub-light-emitting devices on the base substrate and an orthographic projection of the third sub-electrode switch-over portion on the base substrate have an overlapping region.

In a possible implementation, in each first electrode cell, the fourth sub-electrode includes: a fourth sub-electrode body and a fourth sub-electrode switch-over portion extending from the fourth sub-electrode body towards one side away from the second sub-electrode in a direction perpendicular to the second edge; and an orthographic projection of the first groups of holes configured to connect the fourth sub-light-emitting devices on the base substrate and an orthographic projection of the fourth sub-electrode switch-over portion on the base substrate have an overlapping region.

In a possible implementation, each second electrode cell includes a third edge parallel to a long edge of the third sub-electrode and includes a fourth edge parallel to a long edge of the fourth sub-electrode; in the second electrode cell, the third sub-electrode includes: a third sub-electrode body and a third sub-electrode switch-over portion extending from the third sub-electrode body towards one side away from the second sub-electrode in a direction perpendicular to the third edge; and an orthographic projection of the first groups of holes configured to connect the third sub-light-emitting devices on the base substrate and an orthographic projection of the third sub-electrode switch-over portion on the base substrate have an overlapping region.

In a possible implementation, in each second electrode cell, the fourth sub-electrode includes: a fourth sub-electrode body and a fourth sub-electrode switch-over portion extending from the fourth sub-electrode body towards one side close to the first sub-electrode in a direction parallel to the fourth edge; and an orthographic projection of the first groups of holes configured to connect the fourth sub-light-emitting devices on the base substrate and an orthographic projection of the fourth sub-electrode switch-over portion on the base substrate have an overlapping region.

An embodiment of the present disclosure further provides a display panel, including the display substrate provided by the embodiment of the present disclosure.

An embodiment of the present disclosure further provides a display apparatus, including the display panel provided by the embodiment of the present disclosure.

In a possible implementation, the display apparatus further includes an optical module in a first display region.

### Brief Description of the Drawings

Fig. 1 is a schematic top view of a display substrate provided by an embodiment of the present disclosure.
Fig. 2 is a schematic sectional view of a display substrate provided by an embodiment of the present disclosure.
Fig. 3 is a schematic sectional view of another display substrate provided by an embodiment of the present disclosure.
Fig. 4 is a first schematic diagram of a hole arrangement mode of light-emitting devices provided by an embodiment of the present disclosure.
Fig. 5 is a schematic partial enlarged view at a first row gap in Fig. 4.
Fig. 6 is a second schematic diagram of a hole arrangement mode of light-emitting devices provided by an embodiment of the present disclosure.
Fig. 7 is a schematic partial enlarged view of a first electrode cell in Fig. 6.
Fig. 8 is a schematic partial enlarged view of a second electrode cell in Fig. 6.
Fig. 9 is a schematic structural diagram of a display apparatus provided by an embodiment of the present disclosure.
Fig. 10 is a schematic structural diagram of a display apparatus in the related art.

### Detailed Description of the Embodiments

In order to make objectives, technical solutions and advantages of embodiments of the present disclosure clearer, the technical solutions of the embodiments of the present disclosure will be clearly and fully described below with reference to the accompanying drawings of the embodiments of the present disclosure. Apparently, the described embodiments are only some, but not all of the embodiments of the present disclosure. Based on the described embodiments of the present disclosure, all other embodiments obtained by those ordinarily skilled in the art without creative work fall within the protection scope of the present disclosure.

Unless otherwise defined, technical or scientific terms used in the present disclosure should be understood commonly by those ordinarily skilled in the art of the present disclosure. "First", "second" and similar words used in the present disclosure do not denote any sequence, quantity or significance, but are only used for distinguishing different components. "Include" or "contain" or similar words mean that a component or an item preceding the word covers components or items and their equivalents listed after the word without excluding other components or items. "Connection", "connected" and similar words may include electrical connection, direct or indirect, instead of being limited to physical or mechanical connection. "Above", "below", "left", "right" and the like are only used for denoting a relative position relation, and when an absolute position of a described object changes, the relative position relation may also change correspondingly.

"About" or "approximately the same" used herein includes a described value and means that it is within an acceptable deviation range of a specific value determined by a discussed measurement and errors (namely, a limit of a measurement system) related to a measurement of a specific quantity as considered by those ordinarily skilled in the art. For example, "approximately the same" may mean that it is within one or more standard deviation ranges relative to a difference of the described value, or within a range of ±30%, 20%, 10%, and 5%.

In the accompanying drawings, for being clear, thicknesses of a layer, a film, a panel, a region and the like are scaled up. Exemplary implementations are described herein with reference to a cross-section view of a schematic diagram of an ideal implementation. In this way, a deviation between a result of, for example, a fabrication technology and/or an allowance and a shape in the figures is predicted. Thus, implementations described herein should not be construed as being limited to a specific shape of a region shown herein but include a deviation of a shape aspect caused by, for example, fabrication. For example, a flat region illustrated or described may typically have a rough and/or nonlinear feature. Besides, an illustrated sharp-pointed angle maybe round. Therefore, regions shown in the figures are schematic in nature, and their shapes are neither intended to illustrate accurate shapes of the regions nor intended to limit a scope of the claims.

In order to keep the following description of the embodiments of the present disclosure clear and concise, detailed description of known functions and known components are omitted in the present disclosure.

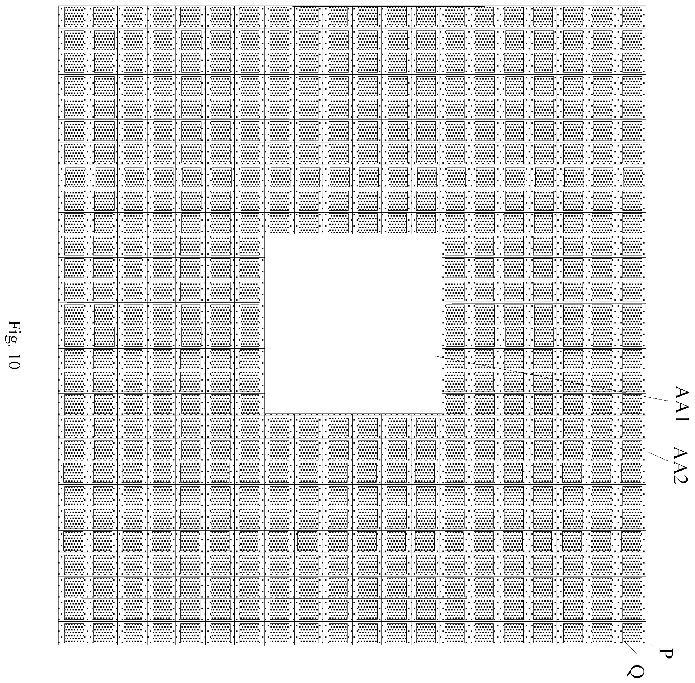

With continuous development of a full screen, in recent two years, following a notch screen and a waterdrop screen, a blind via screen and a through hole screen occur successively so as to further improve a screen-to-body ratio. However, the through hole screen cannot be realized as a real full screen, for no image is displayed on a camera, as shown in Fig. 10, a first display region AA1 is configured to be arranged with a camera. A second display region AA2 is configured to be arranged with a light-emitting device P and a pixel circuit Q driving the light-emitting device P. The light-emitting device P and the pixel circuit Q are not arranged in the first display region AA1. At present, the most popular full screen technology is an under-display camera, and through a special driving design, a camera region can not only display an image, but also have a high transmittance so that a camera conveniently shoots a picture.

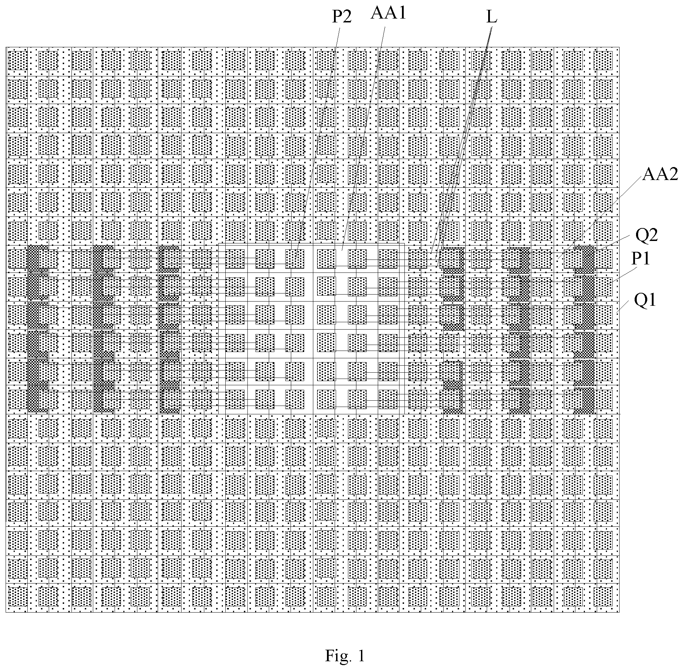

Fig. 1 shows a current under-display camera technology, only a light-emitting device remains in the camera region, but a pixel circuit corresponding to the light-emitting device is arranged outside the camera region. Through transverse compression, a size of the pixel circuit is smaller than a size of the light-emitting device, so more extra pixel circuits may be arranged outside the camera region and are used for driving the light-emitting device in the camera region to realize display. An electrical connection between the pixel circuit outside the camera region and the light-emitting device in the camera region is implemented by using a preferable transparent ITO layer, so as to improve a transmittance to guarantee an effect of taking a picture.

Limited by a process of a transparent wire routing size (pitch), three transparent conductive layers (for example, indium tin oxide (ITO)) are usually used at present for wiring of transparent wires, so three flat layer (PLN) holes are additionally formed in a pixel design. Compressing the pixel circuit and adding the three PLN holes make a layout space compact, when the PLN holes are located in a region where an anode of the light-emitting device is located, consequently, flatness of the anode becomes poor, a problem such as a color cast of a wire substrate is caused, and thus a special design needs to be considered for a full-screen display substrate having an under-display camera.

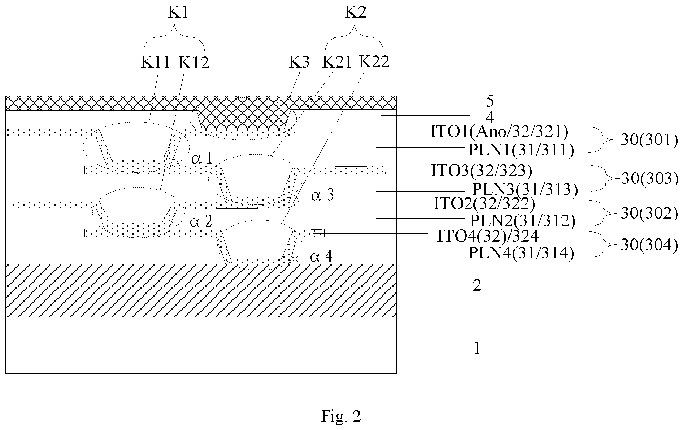

An embodiment of the present disclosure provides a display substrate, as shown in Fig. 1, Fig. 2, Fig. 3 and Fig. 4., and Fig. 2 may be a schematic sectional view of a part of a second display region AA2. The display substrate includes a base substrate 1, a plurality of first pixel circuits Q1, a plurality of first light-emitting devices P1, at least one flat layer 31, at least one conductive layer 32 and a pixel defining layer 4.

The base substrate 1 includes a first display region AA1, and a second display region AA2 at least located on one side of the first display region AA1, wherein a light transmittance of the first display region AA1 is greater than a light transmittance of the second display region AA2. The first display region AA1 may be specifically a region configured to be arranged with an image acquisition component.

The plurality of first pixel circuits Q1 is on one side of the base substrate 1. The display substrate may include a drive circuit layer 2, the drive circuit layer 2 may include the plurality of first pixel circuits Q1, and the plurality of first pixel circuits Q 1 may be arranged in the second display region AA2.

The plurality of first light-emitting devices P1 is on one side of the first pixel circuits Q1 away from the base substrate 1, wherein the first light-emitting device P1 includes a first electrode Ano, and the first electrode Ano may be an anode of the first light-emitting device P1. Each first light-emitting device P1 may further include a light-emitting layer (not shown in the figures) on one side of the first electrode Ano away from the drive circuit layer 2 and a second electrode layer (not shown in the figures) on one side of the light-emitting layer away from the drive circuit layer 2, and the second electrode layer may be a cathode layer. The display substrate may include a light-emitting device layer 5 on one side of the drive circuit layer 2 away from the base substrate, the plurality of first light-emitting devices P1 may be located in the light-emitting device layer 5, and the light-emitting device layer 5 may further include a plurality of second light-emitting devices P2 located in the first display region AA1 and a second pixel circuit Q2 located in the second display region AA2 and driving the second light-emitting devices P2.

At least one flat layer 31 and at least one conductive layer 32 are between the first pixel circuits Q1 and the first light-emitting devices P1, wherein the flat layer 31 and the conductive layer 32 are arranged alternately. At least one of the first pixel circuits Q1 is electrically connected with the first electrode Ano of at least one of the first light-emitting devices P1 via the conductive layer 32 and through a via hole penetrating through the flat layer 31, and the via hole includes a first via hole K11 in contact with the first electrode Ano. The display substrate may include at least one breakover structure layer 30, and each breakover structure layer 30 is located between the drive circuit layer 2 and the light-emitting device layer 5; and each breakover structure layer 30 may include a flat layer 31, and a conductive layer 32 located on one side of the flat layer 31 away from the drive circuit layer.

The pixel defining layer 4 is on one side of the first electrodes Ano away from the base substrate 1. The pixel defining layer may be located between the breakover structure layers 30 and the light-emitting device layer 5; the pixel defining layer 4 includes an opening K3 exposing the first electrode Ano; and an orthographic projection of the opening K3 on the base substrate 1 does not overlap an orthographic projection of the first via hole K11 on the base substrate 1.

In the embodiment of the present disclosure, as for a full-screen display substrate with an optical module, the orthographic projection of the opening K3 exposing the first electrodes Ano on the base substrate 1 does not overlap the orthographic projection of the first via hole K11 in contact with the first electrode Ano on the base substrate 1, so it may be preferably guaranteed that the first via hole K11 in contact with the first electrode Ano does not fall within a region where the opening K3 of the pixel defining layer 4 is located, and thus flatness of the first electrodes Ano may be guaranteed so as to prevent occurrence of the color cast.

During specific implementation, at least one conductive layer 32 may include a plurality of conductive wires L, and at least one second pixel circuit Q2 is electrically connected with at least one second light-emitting device P2 specifically through the conductive wire L.

Optionally, the conductive wire L may be a transparent conductive wire. For example, the conductive wire L may be made of a transparent material such as an indium tin oxide (ITO) or an indium gallium zinc oxide (IGZO). Hypothetically, the conductive wire L is made of an ITO material, so the conductive wire L may also be called an ITO wire. The following embodiments are all described by taking the conductive wire L being the ITO wire as an example.

During specific implementation, the plurality of first light-emitting devices P1 and the first pixel circuits Q1 driving the first light-emitting devices P1 may be arranged in the second display region AA2. In a conventional display substrate, a size (pitch) of the pixel circuit (including the first pixel circuit Q1 and the second pixel circuit Q2) is the same as that of the first light-emitting device P1. For example, in general, a width is about 30 µm to 32 µm, and a length is about 60 µm to 65 µm. In the embodiment of the present disclosure, in order to provide a sufficient space for arrangement of the second pixel circuits Q2 on the premise of not reducing the quantity of pixels in the first display region AA1, each pixel circuit may be compressed in a pixel row direction, so that a width of the pixel circuit in the pixel row direction is smaller than a width of the first light-emitting device P1. In this way, on the premise of the same size of the base substrate 1, more regions can be reserved in the second display region AA2, correspondingly, the second pixel circuits Q2 specially configured to drive the second light-emitting devices P2 in the first display region AA1 may be arranged in the more regions.

For example, a difference between a width of each pixel circuit and a width of the first light-emitting device P1 may be about 4 µm. Taking compressing the pixel circuit and a width difference being 4 µm as an example, specifically, for example, before compression, sizes of the pixel circuit and the light-emitting device are that widths in a direction parallel to the pixel row direction each are in range of 1-100 µm and heights of the pixel circuit and the light-emitting device in a direction perpendicular to the pixel row direction each are in range of 2-200 µm, after compression, the size of the light-emitting device does not change, the height of the pixel circuit does not change, but the width of the pixel circuit is reduced by 1-20 µm, so that one or more extra columns of compressed pixel circuits may exist at intervals of several columns of compressed pixel circuits, and a whole screen adopts this design so as to realize a full screen compression. These extra columns may be selected and used for driving the second light-emitting devices P2 in the first display region AA1 so as to control the second light-emitting devices P2 to emit light. In some embodiments, preferably, the extra columns of pixel circuits close to a periphery of the first display region AA1 are used as the second pixel circuits Q2 to be connected with the second light-emitting devices P2. In this way, normal display may be guaranteed while a resolution of a display panel does not change. Thus, an existing space of the display panel is fully utilized to realize normal display. Specifically, the width of the pixel circuit may refer to a length of an orthographic projection of a layout of the pixel circuit on the base substrate 1 in a direction parallel to the pixel row direction. A width of the second light-emitting device P2 refers to a length of an orthographic projection of an anode of the first light-emitting device P1 on the base substrate 1 in a direction parallel to the pixel row direction.

In a possible implementation, as shown in Fig. 2, the at least one flat layer 31 may include: a first flat layer 311, and a second flat layer 312 on one side of the first flat layer 311 facing the first pixel circuits Q1 (namely, the drive circuit layer 2); the via hole includes the first via hole K11 penetrating through the first flat layer 311 and a second via hole K12 penetrating through the second flat layer 312; and an orthographic projection of the first via hole K11 on the base substrate 1 and an orthographic projection of the second via hole K12 on the base substrate 1 have an overlapping region, and the first via hole K11 and the second via hole K12 form a first group of holes K1. Specifically, a center of the orthographic projection of the first via hole K11 on the base substrate 1 coincides with a center of the orthographic projection of the second via hole K12 on the base substrate 1, and the first group of holes K1 may be sleeving holes. Specifically, a size of the orthographic projection of the first via hole K11 on the base substrate 1 may be approximately the same as a size of the orthographic projection of the second via hole K12 on the base substrate 1, and a ratio of the two is in a range of 0.8-1.2. A length of the orthographic projection of the first via hole K11 on the base substrate 1 in a direction parallel to a row direction of first light-emitting devices P1 may be in a range of 3.0 µm to 3.5 µm, specifically, for example, may be 3.3 µm; and a width of the orthographic projection of the first via hole K11 on the base substrate 1 in a direction perpendicular to a row direction of first light-emitting devices P1 may be in a range of 2.5 µm to 3.0 µm, specifically, for example, may be 2.8 µm. Specifically, a length of the orthographic projection of the second via hole K12 on the base substrate 1 in a direction parallel to a row direction of first light-emitting devices P1 may be in a range of 3.0 µm to 3.5 µm, specifically, for example, may be 3.3 µm; and a width of the orthographic projection of the second via hole K12 on the base substrate 1 in a direction perpendicular to a row direction of first light-emitting devices P1 may be in a range of 2.5 µm to 3.0 µm, specifically, for example, may be 2.8 µm. Specifically, a slope angle of the first via hole K11 may be approximately the same as or different from a slope angle of the second via hole K12. Specifically, the slope angle α1 of the first via hole K11 may be in a range of 40°-70°, specifically, for example, may be 50°. The slope angle α2 of the second via hole K12 may be in a range of 40°-70°, specifically, for example, may be 50°.

In a possible implementation, as shown in Fig. 2, the at least one flat layer 31 further includes a third flat layer 313 between the first flat layer 311 and the second flat layer 312, and a fourth flat layer 314 on one side of the second flat layer 312 away from the third flat layer 313; the via hole further includes: a third via hole K21 penetrating through the third flat layer 313 and a fourth via hole K22 penetrating through the fourth flat layer 314; an orthographic projection of the third via hole K21 on the base substrate 1 and an orthographic projection of the fourth via hole K22 on the base substrate 1 have an overlapping region, the third via hole K21 and the fourth via hole K22 form a second group of holes K2; and the first pixel circuits Q1 are electrically connected with the first electrodes Ano specifically through the first group of holes K1 and the second group of holes K2. Specifically, a center of the orthographic projection of the third via hole K21 on the base substrate 1 coincides with a center of the orthographic projection of the fourth via hole K22 on the base substrate 1, the second group of holes K2 may be sleeving holes, specifically, a size of the orthographic projection of the third via hole K21 on the base substrate 1 may be smaller than a size of the orthographic projection of the fourth via hole K22 on the base substrate 1. A length of the orthographic projection of the third via hole K21 on the base substrate 1 in a direction parallel to a row direction of first light-emitting devices P1 may be in a range of 3.0 µm to 3.5 µm, specifically, for example, may be 3.3 µm, and a width of the orthographic projection of the third via hole K21 on the base substrate 1 in a direction perpendicular to a row direction of first light-emitting devices P1 may be in a range of 2.5 µm to 3.0 µm, specifically, for example, may be 2.8 µm. Specifically, a length of the orthographic projection of the fourth via hole K22 on the base substrate 1 in a direction parallel to a row direction of first light-emitting devices P1 may be in a range of 3.5 µm to 4.0 µm, specifically, for example, may be 3.8 µm, and a width of the orthographic projection of the fourth via hole K22 on the base substrate 1 in a direction perpendicular to a row direction of first light-emitting devices P1 may be in a range of 2.5 µm to 3.0 µm, specifically, for example, may be 2.8 µm. Specifically, a slope angle of the third via hole K21 may be approximately the same as or different from a slope angle of the fourth via hole K22. Specifically, the slope angle α3 of the third via hole K21 may be in a range of 40°-70°, specifically, for example, may be 50°. The slope angle α4 of the fourth via hole K22 may be in a range of 40°-70°, specifically, for example, may be 50°.

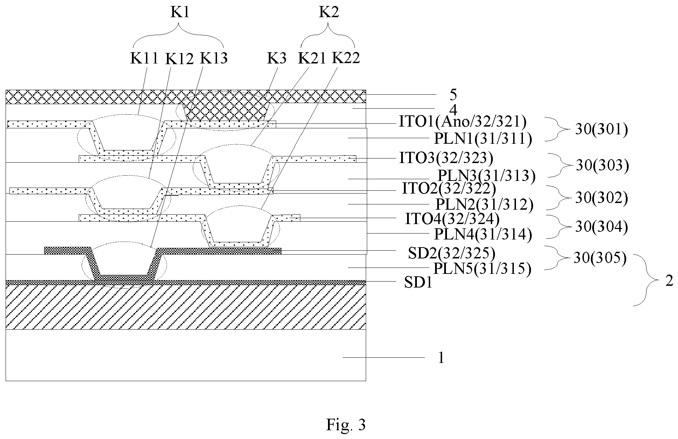

In a possible implementation, as shown in Fig. 3, the at least one flat layer 31 further includes a fifth flat layer 315 on one side of the fourth flat layer 314 away from the second flat layer 312; the via hole further includes: a fifth via hole K13 penetrating through the fifth flat layer 315; and an orthographic projection of the fifth via hole K13 on the base substrate 1 and the orthographic projection of the first via hole K11 on the base substrate 1 have an overlapping region, and the first group of holes K1 further includes the fifth via hole K13. Specifically, a center of the orthographic projection of the fifth via hole K13 on the base substrate 1 coincides with a center of the orthographic projection of the first via hole K11 on the base substrate 1. Specifically, a size of the orthographic projection of the second via hole K12 on the base substrate 1 may be smaller than a size of the orthographic projection of the fifth via hole K13 on the base substrate 1. A length of the orthographic projection of the fifth via hole K13 on the base substrate 1 in a direction parallel to a row direction of first light-emitting devices P1 may be 3.5 µm to 4.0 µm, specifically, for example, may be 3.8 µm, and a width of the orthographic projection of the fifth via hole K13 on the base substrate 1 in a direction perpendicular to the a row direction of first light-emitting devices P1 may be 2.5 µm to 3.0 µm, specifically, for example, may be 2.8 µm. In the embodiment of the present disclosure, when the display substrate further includes the fifth flat layer 315, a fifth conductive layer 325 between the fifth flat layer 315 and the fourth flat layer 314 may be specifically a metal layer, the fifth conductive layer 325 may be specifically a second source-drain layer SD2 in the drive circuit layer 2, specifically, the drive circuit layer 2 may further include a first source-drain layer SD1 on one side of the second source-drain layer SD2 facing the base substrate 1.

In a possible implementation, as shown in Fig. 2 to Fig. 4, an orthographic projection of the second group of holes K2 on the base substrate 1 does not overlap an orthographic projection of the first group of holes K1 on the base substrate 1.

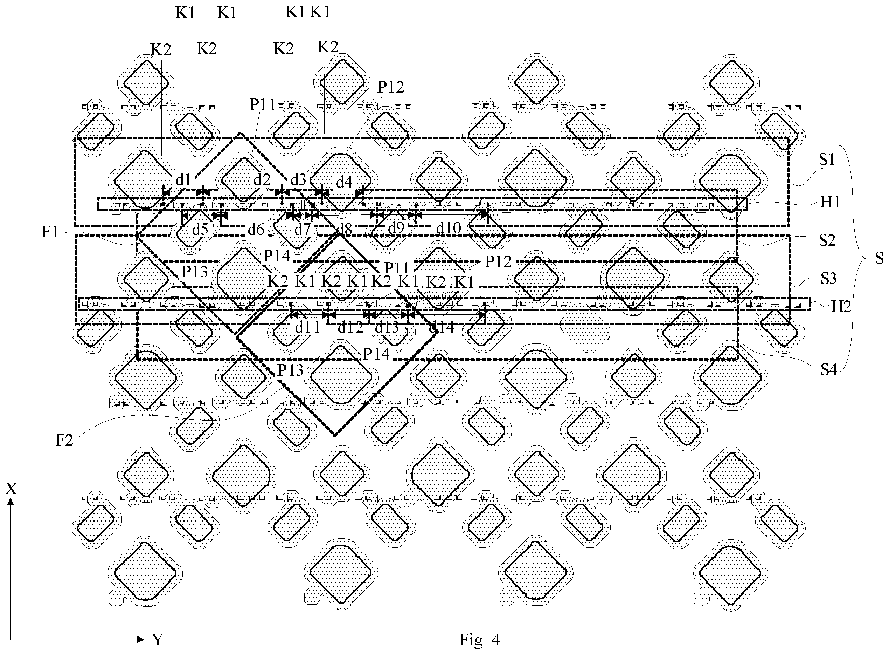

In a possible implementation, as shown in Fig. 4, the plurality of first light-emitting devices P1 include device row groups S arranged in sequence in a first direction X, and each device row group includes a first device row S1, a second device row S2, a third device row S3 and a fourth device row S4 arranged in sequence in the first direction; the first device row S1 and the third device row S3 each include first sub-light-emitting devices P11 and second sub-light-emitting devices P12 arranged alternately in sequence in a second direction Y, a color of light emitted from the first sub-light-emitting devices P11 is different from a color of light emitted from the second sub-light-emitting devices P12; the second device row S2 and the fourth device row S4 each include third sub-light-emitting devices P13 and fourth sub-light-emitting devices P14 arranged alternately in sequence in the second direction Y, and a color of light emitted from the third sub-light-emitting devices P13 is the same as a color of light emitted from the fourth sub-light-emitting devices P14. Specifically, the first sub-light-emitting devices P11 may be red light-emitting devices which emit red light, the second sub-light-emitting devices P12 may be light-emitting devices which emit blue light, and the third sub-light-emitting devices P13 and the fourth sub-light-emitting devices P14 may be green light-emitting devices which emit green light. In the same device row group S, a first row gap H1 exists between the first device row S1 and the second device row S2, and a second row gap H2 exists between the third device row S3 and the fourth device row S4; first groups of holes K1 and second groups of holes K2 configured to connect all the first light-emitting devices P1 in the first device row S1 as well as first groups of holes K1 and second groups of holes K2 configured to connect all the first light-emitting devices P1 in the second device row S2 are all in the first row gap H1 and are arranged in a direction parallel to the second direction Y; and first groups of holes K1 and second groups of holes K2 configured to connect all the first light-emitting devices P1 in the third device rowS3 as well as first groups of holes K1 and second groups of holes K2 configured to connect all the first light-emitting devices P1 in the fourth device row S4 are all in the second row gap H2 and are arranged in a direction parallel to the second direction Y.

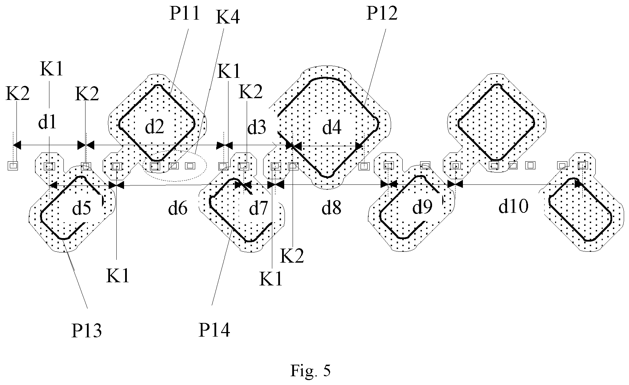

It needs to be noted that a light-emitting region of the first light-emitting devices P1 is usually consistent with a region where the first electrodes Ano are exposed by the openings K3 of the pixel defining layer, so in Fig. 4 and Fig. 5, corresponding light-emitting devices are shown in the region where the first electrodes Ano are exposed by the openings K3 of the pixel defining layer, but the embodiment of the present disclosure is not limited to this, and during specific implementation, the light-emitting devices may further include a plurality of other film layers, for example, may further include a light-emitting layer, a second electrode layer and the like. The following embodiment is described by taking the corresponding light-emitting devices being shown in a region where the first electrodes Ano are as an example.

In a possible implementation, as shown in Fig. 4 and Fig. 5, Fig. 5 is a schematic partial enlarged view at a first row gap H1 in Fig. 4, in the first row gap H1, spacing between centers of at least two adjacent first groups of holes K1 in all the first groups of holes K1 configured to connect the first electrodes Ano is different; in the second row gap H2, spacing between centers of at least two adjacent first groups of holes K1 in all the first groups of holes K1 configured to connect the first electrodes Ano is different. For example, in Fig. 5, in the first row gap H1, spacing d5 between a center of the first group of holes K1 of the third sub-light-emitting device P13 and a center of the first group of holes K1 of the first sub-light-emitting device P11 is different from spacing d6 between the center of the first group of holes K1 of the first sub-light-emitting device P11 and a center of the first group of holes K1 of the fourth sub-light-emitting device P14; the spacing d6 between the center of the first group of holes K1 of the first sub-light-emitting device P11 and the center of the first group of holes K1 of the fourth sub-light-emitting device P14 is different from spacing d7 between the center of the first group of holes K1 of the fourth sub-light-emitting device P14 and a center of the first group of holes K1 of the second sub-light-emitting device P12; and the spacing d7 between the center of the first group of holes K1 of the fourth sub-light-emitting device P14 and the center of the first group of holes K1 of the second sub-light-emitting device P12 is different from spacing d8 between the center of the first group of holes K1 of the second sub-light-emitting device P12 and the center of the first group of holes K1 of the third sub-light-emitting device P13. In the embodiment of the present disclosure, the spacing between the centers of at least two adjacent first groups of holes K1 in all the first groups of holes K1 configured to connect the first electrodes Ano is different, and in the second row gap H2, the spacing between the centers of at least two adjacent first groups of holes K1 in all the first groups of holes K1 configured to connect the first electrodes Ano is different, and it may be preferably guaranteed that the first via holes K11 in contact with the first electrodes Ano do not fall within a region where the opening K3 of the pixel defining layer 4 is located.

Certainly, during specific implementation, in the first row gap H1, in all the first group of holes K1 configured to connect the first electrodes Ano, spacing between centers of every two adjacent first groups of holes K1 of a part or all of the adjacent first groups of holes K1 may also be the same; and in the second row gap H2, in all the first group of holes K1 configured to connect the first electrodes Ano, spacing between centers of every two adjacent first groups of holes K1 of a part or all of the adjacent first groups of holes K1 may also be the same, that is, a part or all of d5, d6, d7 and d8 may also be the same.

In a possible implementation, in the first row gap H1, a ratio of spacing between centers of at least two adjacent second groups of holes K2 in all the second groups of holes K2 configured to connect the first electrodes Ano may be in a range of 0.8-1.2, and the two spacing may be approximately the same; and in the second row gap H2, a ratio of spacing between centers of at least two adjacent second groups of holes K2 in all the second groups of holes K2 configured to connect the first electrodes Ano may be in a range of 0.8-1.2, and the two spacing may be approximately the same. Specifically, for example, in the first row gap H1, spacing d1 between a center of the second group of holes K2 of the third sub-light-emitting device P13 and a center of the second group of holes K2 of the first sub-light-emitting device P11 may be approximately the same as spacing d3 between a center of the second group of holes K2 of the fourth sub-light-emitting device P14 and a center of the second group of holes K2 of the second sub-light-emitting device P12; and the spacing d3 between the center of the second group of holes K2 of the fourth sub-light-emitting device P14 and the center of the second group of holes K2 of the second sub-light-emitting device P12 may be approximately the same as spacing d4 between the center of the second group of holes K2 of the second sub-light-emitting device P12 and the center of the second group of holes K2 of the third sub-light-emitting device P13. In the embodiment of the present disclosure, in the first row gap H1, spacing between centers of at least two adjacent second groups of holes K2 in all the second groups of holes K2 configured to connect the first electrode Ano may be approximately the same; and in the second row gap H2, spacing between centers of at least two adjacent second groups of holes K2 in all the second groups of holes K2 configured to connect the first electrodes Ano may be approximately the same, arrangement of transverse and/or longitudinal signal wires (may include conductive wires L, grid lines, data lines and the like) may be facilitated, moreover, the flat layer 31 is further arranged on one side of the second groups of holes K2 away from the drive circuit layer 2, so though the second groups of holes K2 fall within the region where the opening K3 of the pixel defining layer 4 is located, no large influence is caused to flatness of the first electrodes Ano, and a problem of color cast is not caused.

Certainly, during specific implementation, in the first row gap H1, in all the second groups of holes K2 configured to connect the first electrodes Ano, spacing between centers of every two adjacent second groups of holes K2 of a part or all of the adjacent second groups of holes K2 may also differ; and in the second row gap H2, in all the second groups of holes K2 configured to connect the first electrodes Ano, spacing between centers of every two adjacent second groups of holes K2 of a part or all of the adjacent second groups of holes K2 may also differ, that is, d1, d2, d3 and d4 may also be not completely the same.

In a possible implementation, as shown in Fig. 4 or Fig. 5, the spacing between the centers of the at least two adjacent first groups of holes K1 in the first row gap H1 is different from the spacing between the centers of the at least two adjacent first groups of holes K1 in the second row gap H2. Specifically, for example, as shown in Fig. 4, d7, d8, d9, d10, d11, d12, d13 and d14 are not completely the same, so that it is guaranteed that the first groups of holes K1 do not fall within the region where the opening K3 of the pixel defining layer 4 is located.

In a possible implementation, as shown in Fig. 4, in the first row gap H1, the first groups of holes K1 configured to connect the third sub-light-emitting devices P13, the first groups of holes K1 configured to connect the first sub-light-emitting devices P11, the first groups of holes K1 configured to connect the fourth sub-light-emitting devices P14 and the first groups of holes K2 configured to connect the second sub-light-emitting devices P12 are arranged in cycles in sequence in the second direction Y.

In a possible implementation, as shown in Fig. 4 and Fig. 5, in an arrangement cycle of the first row gap H1, the second groups of holes K2 (namely, the second groups of holes K2 on left side of the third sub-light-emitting devices P13 in Fig. 4 or Fig. 5) of the third sub-light-emitting devices P13 are on one side of the first groups of holes K1 (namely, the first groups of holes K1 located in a region where anodes of the third sub-light-emitting devices P13 are located in Fig. 4 or Fig. 5) of the third sub-light-emitting devices P13 away from the first groups of holes K1 (namely, the first groups of holes K1 in a region where anodes of the first sub-light-emitting devices P11 are located in Fig. 4 or Fig. 5) of the first sub-light-emitting devices P11; the second groups of holes K2 (namely, the second group of holes K2 most adjacent to left side of the first groups of holes K1 of the first sub-light-emitting devices P11 in Fig. 4 or Fig. 5) of the first sub-light-emitting devices P11 are between the first groups of holes K1 of the first sub-light-emitting devices P11 and the first groups of holes K1 (namely, the first groups of holes K1 in the region where the anodes of the third sub-light-emitting devices P13 are located in Fig. 4 or Fig. 5) of the third sub-light-emitting devices P13; the second groups of holes K2 (namely, the second groups of holes K2 most adjacent to left side of the first groups of holes K1 of the fourth sub-light-emitting devices P14 in Fig. 4 or Fig. 5) of the fourth sub-light-emitting devices P14 are between the first groups of holes K1 of the first sub-light-emitting devices P11 and the first groups of holes K1 (namely, the first groups of holes K1 in a region where anodes of the fourth sub-light-emitting devices P14 are located in Fig. 4 or Fig. 5) of the fourth sub-light-emitting devices P14; and the second groups of holes K2 (namely, the second groups of holes K2 most adjacent to right side of the first groups of holes K1 of the second sub-light-emitting devices P12 in Fig. 4 or Fig. 5) of the second sub-light-emitting devices P12 are on one side of the first groups of holes K1 (namely, the first groups of holes K1 in a region where anodes of the second sub-light-emitting devices P12 are located in Fig. 4 or Fig. 5) of the second sub-light-emitting devices P12 away from the first groups of holes K1 of the fourth sub-light-emitting devices P14.

In a possible implementation, as shown in Fig. 4, in the second row gap H2, the first groups of holes K1 configured to connect the third sub-light-emitting devices P13, the first groups of holes K1 configured to connect the first sub-light-emitting devices P11, the first groups of holes K1 configured to connect the fourth sub-light-emitting devices P14 and the first groups of holes K1 configured to connect the second sub-light-emitting devices P12 are arranged in cycles in sequence in the second direction Y.

In a possible implementation, as shown in Fig. 4, in an arrangement cycle of the second row gap H2, the second groups of holes K2 of the third sub-light-emitting devices P13 are on one side of the first groups of holes K1 of the third sub-light-emitting devices P13 away from the first groups of holes K1 of the first sub-light-emitting devices P11; the second groups of holes K2 of the first sub-light-emitting devices P11 are between the first groups of holes K1 of the third sub-light-emitting devices P13 and the first groups of holes K1 of the first sub-light-emitting devices P11; the second groups of holes K2 of the fourth sub-light-emitting devices P14 are between the first groups of holes K1 of the first sub-light-emitting devices P11 and the first groups of holes K1 of the fourth sub-light-emitting devices P14; and the second groups of holes K2 of the second sub-light-emitting devices P12 are between the first groups of holes K1 of the fourth sub-light-emitting devices P14 and the first groups of holes K1 of the second sub-light-emitting devices P 12.

In a possible implementation, a third group of holes K4 may be further included in the first row gap H1 and/or the second row gap H2, the third group of holes K4 may be configured to conduct the conductive wires L to a source-drain layer of the second pixel circuits Q2 when the second light-emitting devices P2 arranged in the first display region AA1 are connected to the second display region AA2 through the conductive wires L.

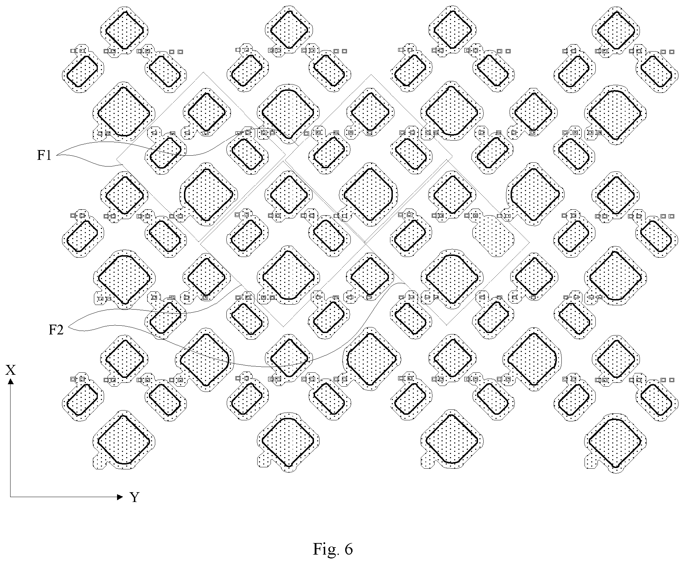

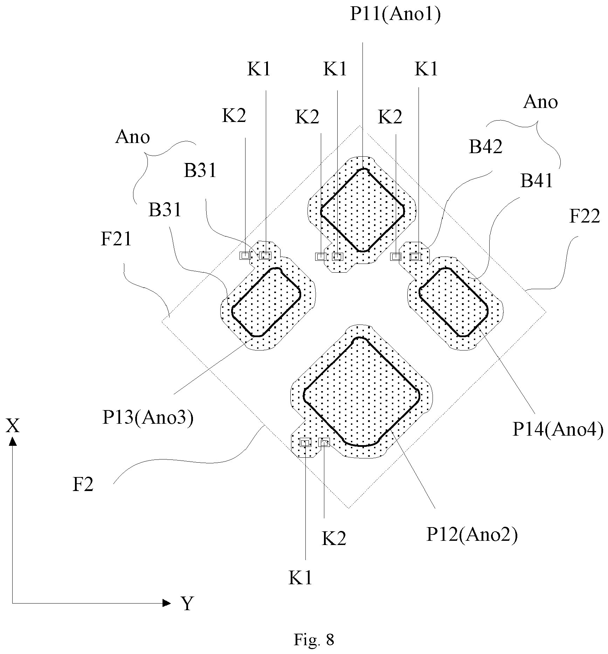

In a possible implementation, as shown in Fig. 6 to Fig. 8, Fig. 7 is a schematic enlarged view of a first electrode cell in Fig. 6, Fig. 8 is a schematic enlarged view of a second electrode cell in Fig. 6, the light-emitting device layer includes first electrode cell rows and second electrode cell rows arranged in sequence in the first direction; the first electrode cell rows include a plurality of first electrode cells F1 arranged in sequence in the second direction Y, and the second electrode cell rows include a plurality of second electrode cells F2 arranged in sequence in the second direction Y; the first electrode cells F1 in the first electrode cell row and the second electrode cells F2 in the second electrode cell row adjacent to each other are arranged in a staggered mode; and the first electrode cell F1 and the second electrode cell F2 each include a first sub-electrode Ano1 and a second sub-electrode Ano2 arranged in the first direction X, and a third sub-electrode Ano3 and a fourth sub-electrode Ano4 arranged in the second direction Y.

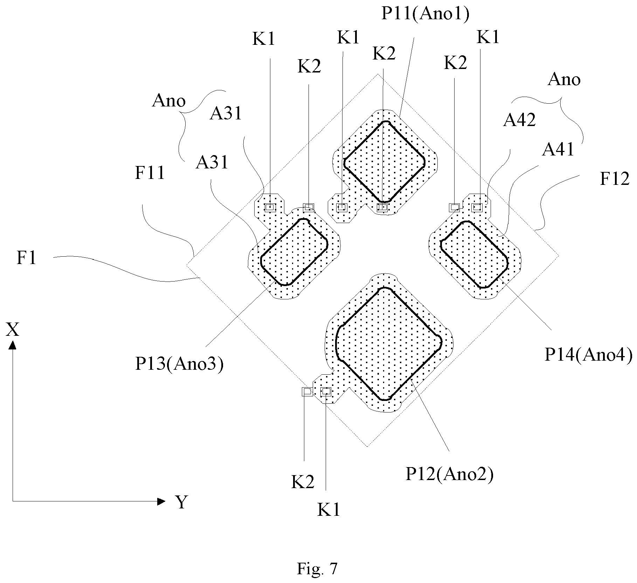

Specifically, an orthographic projection of the third sub-electrode Ano3 on the base substrate 1 is rectangular in shape, and an orthographic projection of the fourth sub-electrode Ano4 on the base substrate 1 is rectangular in shape. In a possible implementation, as shown in Fig. 6 and Fig. 7, each first electrode cell F1 includes a first edge F11 parallel to a long edge of the third sub-electrode Ano3 and includes a second edge F12 parallel to a long edge of the fourth sub-electrode Ano4; in the first electrode cell F1, the third sub-electrode Ano3 includes: a third sub-electrode body A31 and a third sub-electrode switch-over portion A32 extending from the third sub-electrode body A31 towards one side away from the second sub-electrode Ano2 in a direction perpendicular to the first edge F11; and an orthographic projection of the first groups of holes K1 configured to connect the third sub-light-emitting devices P13 on the base substrate 1 and an orthographic projection of the third sub-electrode switch-over portion A32 on the base substrate 1 have an overlapping region.

In a possible implementation, as shown in Fig. 6 and Fig. 7, in each first electrode cell F1, the fourth sub-electrode Ano4 includes: a fourth sub-electrode body A41 and a fourth sub-electrode switch-over portion A42 extending from the fourth sub-electrode body A41 towards one side away from the second sub-electrode Ano2 in a direction perpendicular to the second edge F12; and an orthographic projection of the first groups of holes K1 configured to connect the fourth sub-light-emitting devices P14 on the base substrate 1 and an orthographic projection of the fourth sub-electrode switch-over portion A42 on the base substrate 1 have an overlapping region.

In a possible implementation, as shown in Fig. 6 and Fig. 8, each second electrode cell F2 includes a third edge F21 parallel to a long edge of the third sub-electrode Ano3 and includes a fourth edge F22 parallel to a long edge of the fourth sub-electrode Ano4; in the second electrode cell F2, the third sub-electrode Ano3 includes: a third sub-electrode body B31 and a third sub-electrode switch-over portion B32 extending from the third sub-electrode body B31 towards one side away from the second sub-electrode Ano2 in a direction perpendicular to the third edge F21; and an orthographic projection of the first groups of holes K1 configured to connect the third sub-light-emitting devices P13 on the base substrate 1 and an orthographic projection of the third sub-electrode switch-over portion B32 on the base substrate 1 have an overlapping region.

In a possible implementation, as shown in Fig. 6 and Fig. 8, in each second electrode cell F2, the fourth sub-electrode Ano4 includes: a fourth sub-electrode body B41 and a fourth sub-electrode switch-over portion B42 extending from the fourth sub-electrode body B41 towards one side close to the first sub-electrode Ano1 in a direction parallel to the fourth edge F22; and an orthographic projection of the first groups of holes K1 configured to connect the fourth sub-light-emitting devices P14 on the base substrate 1 and an orthographic projection of the fourth sub-electrode switch-over portion B42 on the base substrate 1 have an overlapping region.

In a possible implementation, as shown in Fig. 4 to Fig. 8, via holes corresponding to a part of first electrodes Ano adjacent in a row direction are formed between the two first electrodes Ano, and via holes corresponding to a part of first electrodes Ano adjacent in the row direction are formed in the same side of the two first electrodes Ano and a part of via holes are formed in opposite side.

In a possible implementation, as shown in Fig. 4 to Fig. 8, a distance between the via holes corresponding to a part of first electrodes Ano and an opening of a pixel defining layer of a sub-pixel where the first electrodes Ano are located is greater than a distance between the via holes and an adjacent opening, and a distance between via holes corresponding to a part of first electrodes Ano and an opening of a pixel defining layer of a sub-pixel where the first electrodes Ano are located is smaller than a distance between the via hole and an adjacent opening.

In a possible implementation, each first group of holes K1 and each second group of holes K2 may be aligned in the row direction. In another possible implementation, each first group of holes K1 and each second group of holes K2 may be not aligned in the row direction. In another possible implementation, all first groups of holes K1 and all second groups of holes K2 may be partially aligned and partially not aligned in the row direction.

In a possible implementation, via holes in the same layer may be aligned, via holes in different layers may be not aligned, or on the contrary, in another possible implementation, the via holes in the same layer may be not aligned, and the via holes in the different layers may be aligned.

In a possible implementation, each opening is at least provided with a via hole in a left side and a right side in a direction parallel to a row direction of the first light-emitting device, so as to guarantee that the two sides do not tilt too much.

During specific implementation, in a possible implementation, each first light-emitting device P1 in the same row as the second light-emitting device P2 in the second display region AA2 may have a hole arrangement mode shown in Fig. 2 to Fig. 8.

Based on the same inventive concept, an embodiment of the present disclosure further provides a display panel, including the display substrate provided by the embodiment of the present disclosure.

Based on the same inventive concept, an embodiment of the present disclosure further provides a display apparatus, including the display panel provided by the embodiment of the present disclosure. The display panel may be an organic light emitting diode (OLED) display panel, a quantum dot light emitting diode (QLED) display panel or a micro light emitting diode (Micro LED) display panel. As a principle of solving problems of the display panel is similar to a principle of solving problems of the above display substrate, implementation of the display panel provided by the embodiment of the present disclosure may refer to implementation of the above display substrate, and repetitions are omitted.

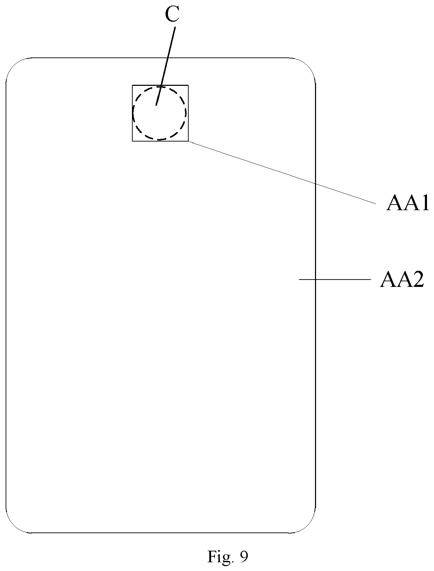

In a possible implementation, as shown in Fig. 9, the display apparatus further includes an optical module in a first display region AA1. Specifically, the optical module may be a camera module C or other optical modules and the like. As a principle of solving problems of the display apparatus is similar to the principle of solving problems of the above display substrate, implementation of the display apparatus provided by the embodiment of the present disclosure may refer to implementation of the above display substrate, and repetitions are omitted.

Specifically, the camera module C may be directly arranged in the first display region AA1, that is, an extra hole does not need to be punched in the display panel. In this way, a solid foundation is laid for implementation of a full-screen display panel.

Optionally, the first display region AA1 may be rectangular, an area of the orthographic projection of the camera module C on the base substrate 1 may be smaller than or equal to an area of an incircle of the first display region AA1. In other words, a size of a region where the camera module C is located may be smaller than or equal to the size of the incircle of the first display region AA1. For example, with reference to Fig. 9, in the display apparatus shown in the figure, the size of the region where the camera module C is located is equal to the size of the incircle of the first display region AA1, that is, a shape of the region where the camera module C is located may be circular, and correspondingly, the region where the camera module C is located may also be called a light transmitting hole. Certainly, in some embodiments, the first display region AA1 may also be other shapes besides the rectangle, such as a circle or an ellipse.

In some embodiments, the display apparatus may be: a mobile phone, a tablet computer, a television, a display, a notebook computer, a digital photo frame, a navigator, a smartwatch, a fitness wristband, a personal digital assistant and any product or component with a display function. The display apparatus may include but is not limited to: a radio frequency unit, a network module, an audio output unit, an input unit, a sensor, a display unit, a user input unit, an interface unit, a memory, a processor, a power supply and other components. Those skilled in the art can understand that a structure of the above display apparatus does not constitute a limitation on the display apparatus, and the display apparatus may include more or less components than above, or combine some components, or different arrangements of the components.

Though the preferred embodiments of the present disclosure are already described, those skilled in the art can make extra changes and modifications to these embodiments once they know a basic inventive concept. Therefore, the appended claims are intended to be construed as including the preferred embodiments and all changes and modifications falling within the scope of the present disclosure.

Apparently, those skilled in the art can make various changes and variations to the embodiments of the present disclosure without departing from the spirit and scope of the embodiments of the present disclosure. In this case, if these modifications and variations of the embodiments of the present disclosure fall within the scope of the claims of the present disclosure and their equivalents, the present disclosure also intends to contain these modifications and variations.

## Claims

1. A display substrate, comprising:
a base substrate;
a plurality of first pixel circuits on one side of the base substrate;
a plurality of first light-emitting devices on one side of the first pixel circuits away from the base substrate, wherein each of the first light-emitting devices comprises a first electrode;
at least one flat layer and at least one conductive layer, between the first pixel circuits and the first light-emitting devices, wherein the flat layer and the conductive layer are arranged alternately, at least one of the first pixel circuits is electrically connected with the first electrode of at least one of the first light-emitting devices via the conductive layer and through a via hole penetrating through the flat layer, and the via hole comprises a first via hole in contact with the first electrode; and
a pixel defining layer on one side of the first electrodes away from the base substrate and comprising an opening exposing the first electrode, wherein an orthographic projection of the opening on the base substrate does not overlap an orthographic projection of the first via hole on the base substrate.

2. The display substrate according to claim 1, wherein the at least one flat layer comprises: a first flat layer, and a second flat layer located on one side of the first flat layer facing the first pixel circuits; the via hole comprises the first via hole penetrating through the first flat layer and a second via hole penetrating through the second flat layer; and
an orthographic projection of the first via hole on the base substrate and an orthographic projection of the second via hole on the base substrate have an overlapping region, and the first via hole and the second via hole form a first group of holes.

3. The display substrate according to claim 2, wherein the at least one flat layer further comprises a third flat layer between the first flat layer and the second flat layer, and a fourth flat layer on one side of the second flat layer away from the third flat layer; the via hole further comprises: a third via hole penetrating through the third flat layer and a fourth via hole penetrating through the fourth flat layer;
an orthographic projection of the third via hole on the base substrate and an orthographic projection of the fourth via hole on the base substrate have an overlapping region, the third via hole and the fourth via hole form a second group of holes; and the first pixel circuit is electrically connected with the first electrode through the first group of holes and the second group of holes.

4. The display substrate according to claim 3, wherein the at least one flat layer further comprises a fifth flat layer on one side of the fourth flat layer away from the second flat layer; the via hole further comprises: a fifth via hole penetrating through the fifth flat layer; and
an orthographic projection of the fifth via hole on the base substrate and the orthographic projection of the first via hole on the base substrate have an overlapping region, and the first group of holes further comprises the fifth via hole.

5. The display substrate according to claim 3 or 4, wherein an orthographic projection of the second group of holes on the base substrate does not overlap an orthographic projection of the first group of holes on the base substrate.

6. The display substrate according to any one of claims 3-5, wherein the plurality of first light-emitting devices comprise device row groups arranged in sequence in a first direction, and each of the device row groups comprises a first device row, a second device row, a third device row and a fourth device row arranged in sequence in the first direction;
the first device row and the third device row each comprise first sub-light-emitting devices and second sub-light-emitting devices arranged alternately in sequence in a second direction, a color of light emitted from the first sub-light-emitting devices is different from a color of light emitted from the second sub-light-emitting devices; and the second device row and the fourth device row each comprise third sub-light-emitting devices and fourth sub-light-emitting devices arranged alternately in sequence in the second direction, and a color of light emitted from the third sub-light-emitting devices is the same as a color of light emitted from the fourth sub-light-emitting devices;
in the same device row group, a first row gap is between the first device row and the second device row, and a second row gap is between the third device row and the fourth device row; first groups of holes and second groups of holes configured to connect all the first light-emitting devices in the first device row as well as first groups of holes and second groups of holes configured to connect all the first light-emitting devices in the second device row are all in the first row gap and are arranged in a direction parallel to the second direction; and first groups of holes and second groups of holes configured to connect all the first light-emitting devices in the third device row as well as first groups of holes and second groups of holes configured to connect all the first light-emitting devices in the fourth device row are all located in the second row gap and are arranged in a direction parallel to the second direction.

7. The display substrate according to claim 6, wherein in the first row gap, spacing between centers of at least two adjacent first groups of holes in all the first groups of holes configured to connect the first electrodes is different; and
in the second row gap, spacing between centers of at least two adjacent first groups of holes in all the first groups of holes configured to connect the first electrodes is different.

8. The display substrate according to claim 6 or 7, wherein in the first row gap, a ratio of spacing between centers of at least two adjacent second groups of holes in all the second groups of holes configured to connect the first electrodes is in a range of 0.8-1.2; and
in the second row gap, a ratio of spacing between centers of at least two adjacent second groups of holes in all the second groups of holes configured to connect the first electrodes is in a range of 0.8-1.2.

9. The display substrate according to any one of claims 6-8, wherein spacing between centers of at least two adjacent first groups of holes in the first row gap is different from spacing between centers of at least two adjacent first groups of holes in the second row gap.

10. The display substrate according to any one of claims 6-9, wherein in the first row gap, first groups of holes configured to connect the third sub-light-emitting devices, first groups of holes configured to connect the first sub-light-emitting devices, first groups of holes configured to connect the fourth sub-light-emitting devices and first groups of holes configured to connect the second sub-light-emitting devices are arranged in cycles in sequence in the second direction.

11. The display substrate according to claim 10, wherein in an arrangement cycle of the first row gap,
second groups of holes of the third sub-light-emitting devices are on one side of the first groups of holes of the third sub-light-emitting devices away from the first groups of holes of the first sub-light-emitting devices;
second groups of holes of the first sub-light-emitting devices are between the first groups of holes of the first sub-light-emitting devices and the first groups of holes of the third sub-light-emitting devices;
second groups of holes of the fourth sub-light-emitting devices are between the first groups of holes of the first sub-light-emitting devices and the first groups of holes of the fourth sub-light-emitting devices; and
second groups of holes of the second sub-light-emitting devices are on one side of the first groups of holes of the second sub-light-emitting devices away from the first groups of holes of the fourth sub-light-emitting devices.

12. The display substrate according to any one of claims 6-9, wherein in the second row gap, first groups of holes configured to connect the third sub-light-emitting devices, first groups of holes configured to connect the first sub-light-emitting devices, first groups of holes configured to connect the fourth sub-light-emitting devices and first groups of holes configured to connect the second sub-light-emitting devices are arranged in cycles in sequence in the second direction.

13. The display substrate according to claim 9, wherein in an arrangement cycle of the second row gap,
second groups of holes of the third sub-light-emitting devices are located on one side of the first groups of holes of the third sub-light-emitting devices away from the first groups of holes of the first sub-light-emitting devices;
second groups of holes of the first sub-light-emitting devices are between the first groups of holes of the third sub-light-emitting devices and the first groups of holes of the first sub-light-emitting devices;
second groups of holes of the fourth sub-light-emitting devices are between the first groups of holes of the first sub-light-emitting devices and the first groups of holes of the fourth sub-light-emitting devices; and
second groups of holes of the second sub-light-emitting devices are between the first groups of holes of the fourth sub-light-emitting devices and the first groups of holes of the second sub-light-emitting devices.

14. The display substrate according to any one of claims 9-13, wherein a plurality of first electrodes of the plurality of first light-emitting devices comprise first electrode cell rows and second electrode cell rows arranged in sequence in the first direction; the first electrode cell rows comprise a plurality of first electrode cells arranged in sequence in the second direction, and the second electrode cell rows comprises a plurality of second electrode cells arranged in sequence in the second direction; and
the first electrode cell and the second electrode cell each comprise a first sub-electrode and a second sub-electrode arranged in the first direction, and a third sub-electrode and a fourth sub-electrode arranged in the second direction.

15. The display substrate according to claim 14, wherein the first electrode cell comprises a first edge parallel to a long edge of the third sub-electrode and comprises a second edge parallel to a long edge of the fourth sub-electrode;
in the first electrode cell, the third sub-electrode comprises: a third sub-electrode body and a third sub-electrode switch-over portion extending from the third sub-electrode body towards one side away from the second sub-electrode in a direction perpendicular to the first edge; and an orthographic projection of first groups of holes configured to connect the third sub-light-emitting devices on the base substrate and an orthographic projection of the third sub-electrode switch-over portion on the base substrate have an overlapping region.

16. The display substrate according to claim 14, wherein in the first electrode cell, the fourth sub-electrode comprises: a fourth sub-electrode body and a fourth sub-electrode switch-over portion extending from the fourth sub-electrode body towards one side away from the second sub-electrode in a direction perpendicular to the second edge; and
an orthographic projection of first groups of holes configured to connect the fourth sub-light-emitting devices on the base substrate and an orthographic projection of the fourth sub-electrode switch-over portion on the base substrate have an overlapping region.

17. The display substrate according to any of claims 14-16, wherein the second electrode cell comprises a third edge parallel to a long edge of the third sub-electrode and comprises a fourth edge parallel to a long edge of the fourth sub-electrode;
in the second electrode cell, the third sub-electrode comprises: a third sub-electrode body and a third sub-electrode switch-over portion extending from the third sub-electrode body towards one side away from the second sub-electrode in a direction perpendicular to the third edge; and an orthographic projection of first groups of holes configured to connect the third sub-light-emitting devices on the base substrate and an orthographic projection of the third sub-electrode switch-over portion on the base substrate have an overlapping region.

18. The display substrate according to claim 17, wherein in each second electrode cell, the fourth sub-electrode comprises: a fourth sub-electrode body and a fourth sub-electrode switch-over portion extending from the fourth sub-electrode body towards one side close to the first sub-electrode in a direction parallel to the fourth edge; and
an orthographic projection of first groups of holes configured to connect the fourth sub-light-emitting devices on the base substrate and an orthographic projection of the fourth sub-electrode switch-over portion on the base substrate have an overlapping region.

19. A display panel, comprising the display substrate according to any one of claims 1-18.

20. A display apparatus, comprising the display panel according to claim 19.

21. The display apparatus according to claim 20, further comprising an optical module in a first display region.
